# EUROPEAN PATENT APPLICATION

(11) **EP 1 830 618 A1**
(43) Date of publication of application: **05.09.2007**
(21) Application number: 05105477.3
(22) Date of filing: 21.06.2005
(51) Int. Cl.: H05K 5/02, G06K 7/00, G06K 13/08

(54) **Card connector**

(71) Applicant: Tyco Electronics AMP K.K., Kawasaki-shi, Kanagawa 213-8535 (JP)
(72) Inventor: Taguchi, Hidenori, c/oTyco Electronics AMP K.K., Kawasaki-shi, Kanagawa 213-8535 (JP)
(74) Representative: Johnstone, Douglas Ian

(57) **Abstract**

This invention provides a card connector (100) including a main body (1), an ejection mechanism (2) and a triangular-shaped stopper member (3). The main body (1) is a composite socket structure and has a shoulder (10) formed at one lateral side thereof and a plurality of terminals formed at a front side of the main body. The ejection mechanism (2) is disposed at the lateral side of the main body (1) above the shoulder (10) for positioning a card (4, 5) in the card connector (100) or ejecting the card (4, 5) from the card connector (100). The stopper member guides the insertion and positioning of the card in the card connector (100). The stopper member (3) is disposed at the shoulder (10). By pushing the ejection mechanism (2), the card can be rapidly inserted and positioned in the card connector. Once the card pushes the ejection mechanism again, the card is ejected from the card connector.

## Description

The present invention relates to a card connector, and more particularly to a card connector capable of rapidly positioning and ejecting a card.

The PCMCIA (Personal Computer Memory Card International Association) interface is used in computers and their peripheral devices. The PCMCIA interface primarily enacts a standard specification of a computer memory card. An IC card meeting the standard is called PCMCIA card (briefly named PC card) and a socket meeting the standard is called PCMCIA socket. The PCMCIA card is widely used to connect a computer to a peripheral device. It is necessary to connect external peripheral devices to a notebook computer since many are confined by their size. Hence, the PCMCIA interface can be an important interface. Until recently, the PC card was primarily used to transmit data from a notebook computer, or as a local area network card, to eliminate problems associated with carrying bulky peripheral devices.

For the purpose of providing a better transmission interface, PCMCIA developed an Express card, which is lighter, thinner, faster, easier to use and suitable for more I/O (input/output) models than the conventional PC card. The Express card has two specifications: Express card/34 (small card) with a width of 34 mm and Express card/54 (big card) with a width of 54 mm.

When the Express card is inserted into the card connector, the Express card engages with the socket of the card connector, and a finger urges the Express card into the socket. During insertion, the user will take time to align the card with the receiving end of the card connector due to different specifications of the cards. Therefore, the card can not be rapidly inserted and positioned in the card connector. Moreover, during insertion, the user applies force to push the card into the connector, but cannot be certain whether the card has been inserted into the card connector correctly or not. The card connector is, over the long-term, subject to force and can therefore be easily damaged.

An objective of the present invention is to provide a card connector provided with an ejection mechanism at one lateral side thereof to rapidly position and eject the card.

According to the above objective, the present invention provides a card connector including a main body and an ejection mechanism. The main body has a first hook member or hook portion disposed at one side thereof. The ejection mechanism has a push block, an ejection bar, a positioning block and a spring. The push block is provided with an abutting portion at one side thereof and a second hook member or hook portion at the opposite side. A through hole is formed at the push block above the second hook member or hook portion. The ejection bar is provided with an L-shaped bend portion at one end thereof and a protruding guide portion at the opposite end. The positioning block is provided with a first guiding groove and a second guiding groove. The spring has two fastening portions respectively at its two ends. When the ejection mechanism and the main body are assembled, the ejection mechanism is disposed at one lateral side of the main body, the L-shaped bend portion passes through the through hole and connects with the push block, the protruding guide portion of the ejection bar is received in the first guiding groove of the positioning block, and the first hook member and the second hook portion respectively hook the fastening portions of the spring. When a card pushes the abutting portion of the push block, the spring generates a spring force to facilitate the card to rapidly position in the card connector. When the card is pushed again, the card pushes the ejection mechanism once again, and the spring generates a spring-back force to eject the card from the card connector.

Preferably, the main body is a composite socket and has a shoulder provided at one lateral side of the main body and under the ejection mechanism.

The card connector may further comprise a triangular-shaped stopper member for guiding a small card to position in the card connector, and the stopper member is disposed at the shoulder.

The card connector may further comprise a shield mechanism having a fixed plate disposed at the shoulder and an L-shaped block disposed at an insert end of the main body. The L-shaped block is pivotably connected with the fixed plate.

Preferably, the fixed plate has a first guiding portion, a second guiding portion and a slot. The first guiding portion is disposed at a pivot position of the fixed plate and the L-shaped block. The second guiding portion is disposed at one end of the fixed plate opposite to the first guiding portion. The slot is disposed between the first guiding portion and the second guiding portion. The first guiding portion and second guiding portion are used for guiding the card to rapidly insert the card connector. The L-shaped block has a vertical extending portion, which can be received in the slot.

Preferably, the composite socket can accommodate a card with a specification of Express card/34 or Express card/54.

A protruding block may extend from an inner wall of the push block for abutting the ejection bar when the push block and the positioning block are assembled.

Embodiments of the present invention will now be described, by way of example only, and with reference to the accompanying schematic drawings, in which:
Fig. 1 is a structure of a card connector of the present invention;
Fig. 2A is an exploded view of the card connector of Fig. 1;
Fig. 2B is a side view of the card connector of Fig. 1;
Fig. 3A is an exploded view of an ejection mechanism of the card connector of Fig. 1;
Fig. 3B is a partial cross-sectional view of the ejection mechanism of Fig. 3A;
Fig. 3C is a cross-sectional view of the positioning block of Fig. 3A;
Fig. 4 shows a small card being inserted into the card connector of Fig. 1;
Fig. 5 shows a larger card being inserted into the card connector of Fig. 1;
Fig. 6 is a view showing the small card accommodated in the card connector of Fig. 1;
Fig. 7 shows a top view of the card connector of Fig. 1 including a shield mechanism;
Fig. 8A is a perspective view of the shield mechanism of Fig. 7; and
Fig. 8B is another perspective view of the shield mechanism of Fig. 7 in which a vertical extending portion is received in a slot of the shield mechanism.

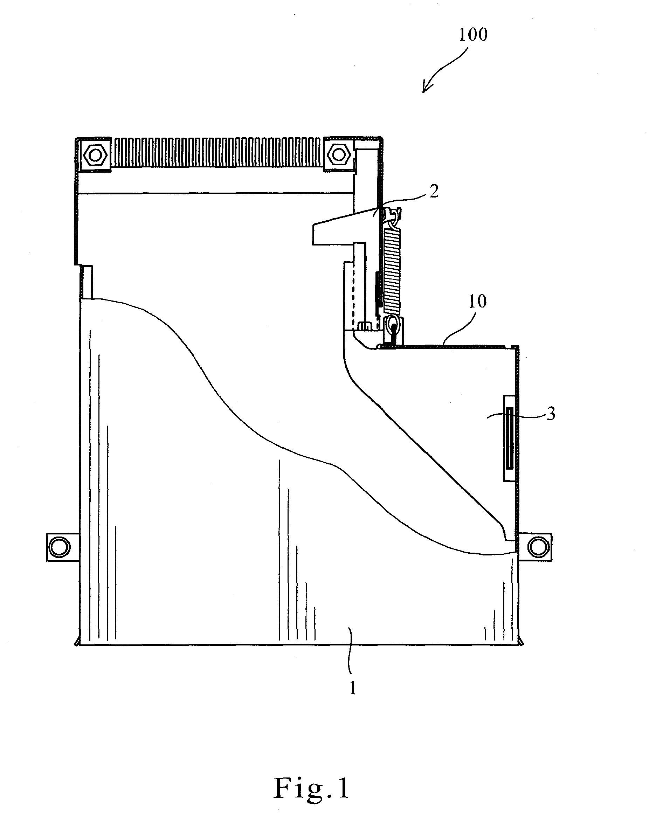

Fig. 1, shows a structure of a card connector 100 of the present invention. The card connector 100 includes a main body 1, an ejection mechanism 2 and a triangular-shaped stopper member 3. The main body 1 is a composite socket, and a shoulder 10 is disposed at one lateral side of the main body 1. The main body 1 has a plurality of terminals provided at a front side thereof. The ejection mechanism 2 is disposed at the lateral side of the main body 1 above the shoulder 10 for positioning a card in the card connector 100 or ejecting the card from the card connector 100. The stopper member 3 is used for guiding the card to position in the card connector 100 and is disposed at the shoulder 10.

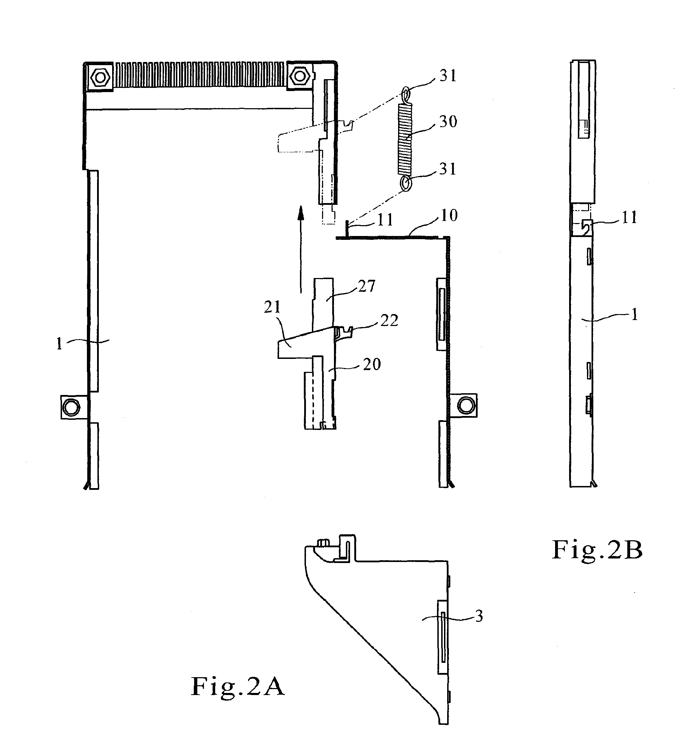

As shown in Fig. 1 to Fig. 3C, the main body 1 is provided with a first hook member 11 on the shoulder 10. The main body 1 is disposed on a printed circuit board (not shown). The ejection mechanism 2 includes a push block 20, an ejection bar 24, a positioning block 27 and a spring 30. The push block 20 has an abutting portion 21 extended from one side thereof and a second hook portion 22 formed at the opposite side. A protruding block 32 extends from an inner wall of the push block 20, and a through hole 23 is formed at the push block 20 above the second hook portion 22. The ejection bar 24 is provided with an L-shaped bend portion 25 at one end thereof and a protruding guide portion 26 at the opposite end. The positioning block 27 has a first guiding groove 28 and a second guiding groove 29 formed at one side thereof. The spring 30 has two fastening portions 31 formed at two ends thereof.

The L-shaped bend portion 25 of the ejection bar 24 passes through the through hole 23 of the push block 20 such that the ejection bar 24 is associated or linked with the push block 20. The positioning block 27 moves along the inner wall of the push block 20 to associate or engage with the push block 20, the protruding guide portion 26 is received in the first guiding groove 28 and the protruding block 32 abuts the ejection bar 24 to secure the ejection bar 24. The assembled push block 20 and positioning block 27 are disposed at the lateral side of the main body 1 above the shoulder 10. The first hook member 11 on the shoulder 10 hooks in a fastening portion 31 of the spring 30 and the second hook portion 22 of the push block 20 hooks in the other fastening portion 31 of the spring 30 so as to position the push block 20 and the positioning block 27 at the lateral side of the main body 1. The stopper member 3 is disposed at the shoulder 10.

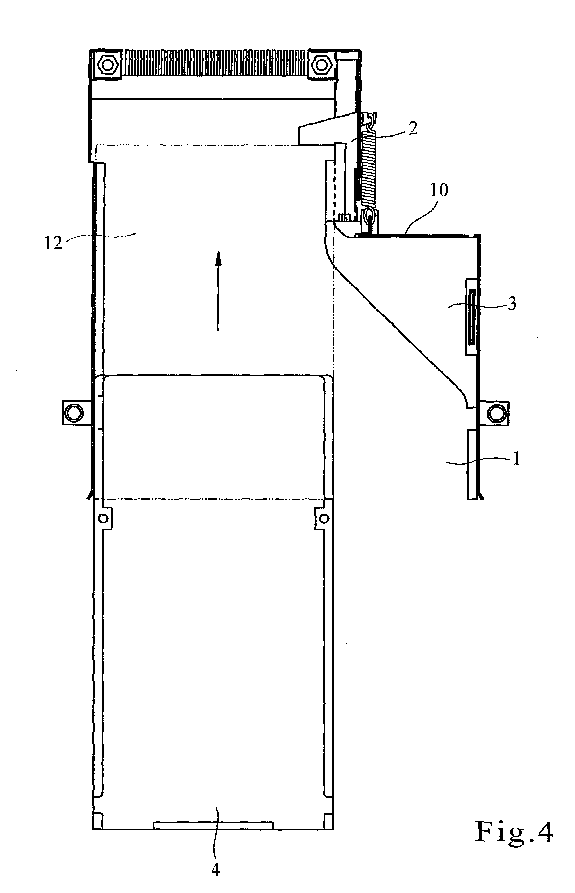

Fig. 4 shows a small card 4 partially inserted into the card connector 100 of the present invention. A first accommodating space 12 is defined by a left-side wall of the main body 1 and the ejection mechanism 2. The first accommodating space 12 accommodates the small card 4. The small card 4 forwardly pushes the ejection mechanism 2 until the top of the main body 1 and then the small card 4 is positioned in the card connector 100.

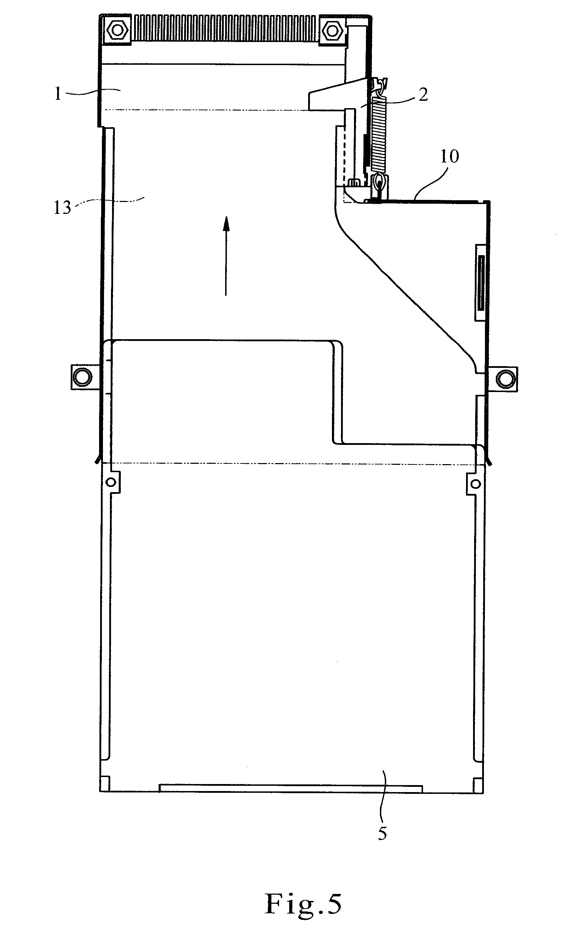

Fig. 5 shows a larger card 5 partially inserted into the card connector 100 of the present invention. A second accommodating space 13 is defined by a front side of the main body 1, the shoulder 10 and the left-side wall of the main body 1. The second accommodating space 13 accommodates the big card 5. The big card 5 forwardly pushes the ejection mechanism 2 until the top of the main body 1 and then the big card 5 is positioned in the card connector 100.

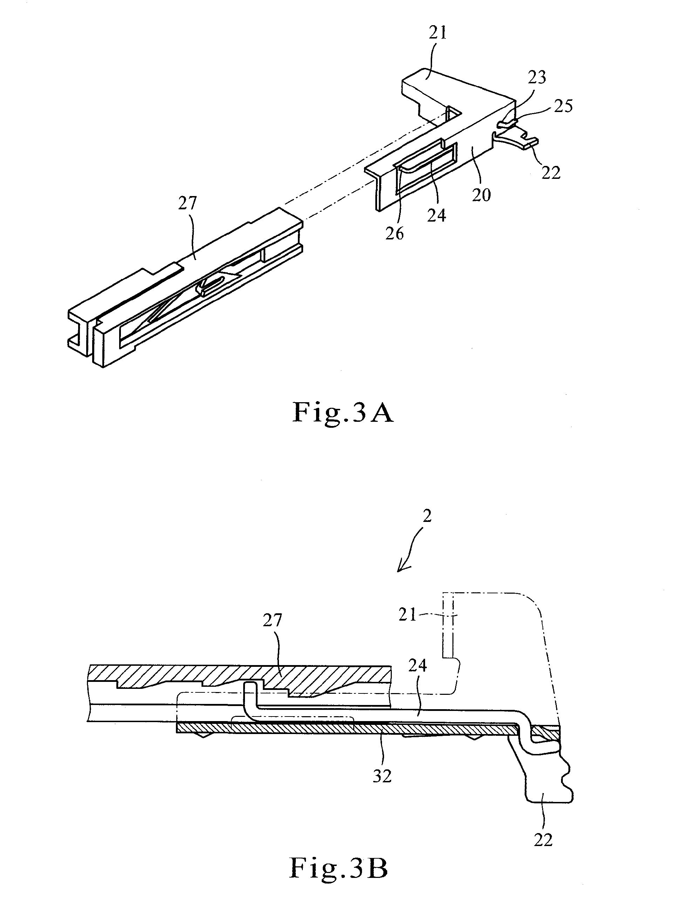

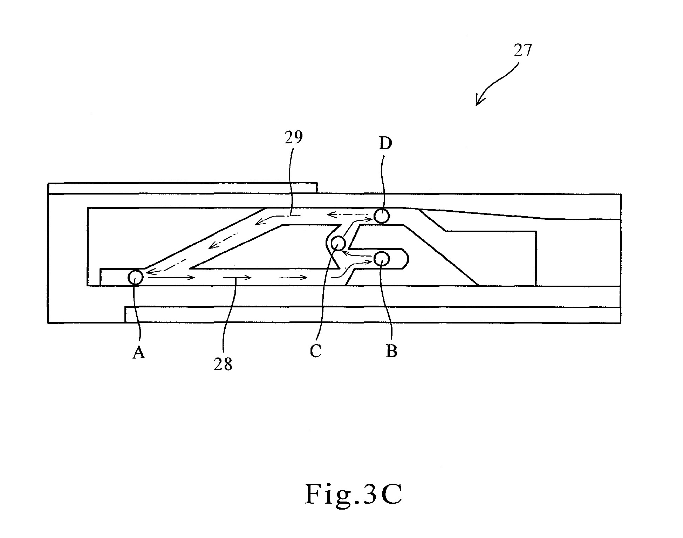

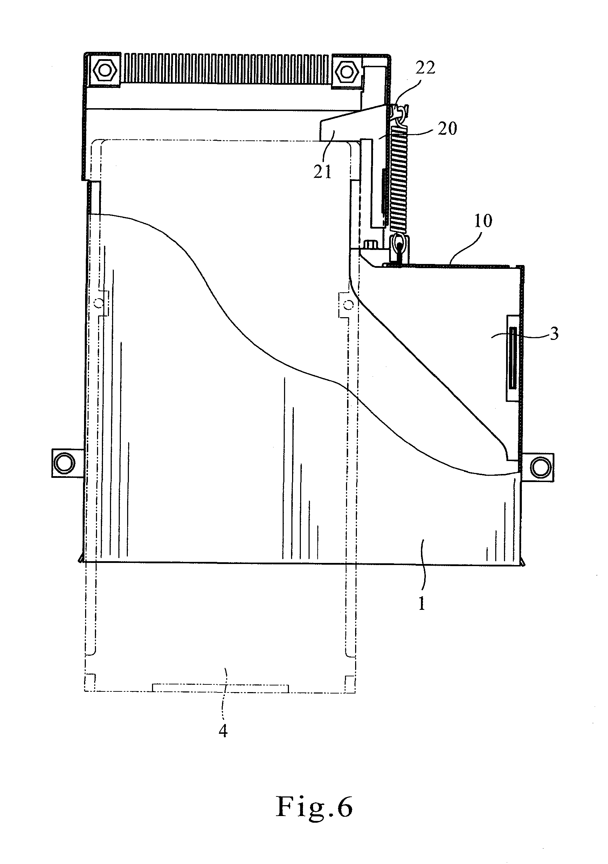

Fig.3C, Fig.4 and Fig. 6, show the small card 4 accommodated in the card connector 100. When the small card 4 is to be inserted in the card connector 100, the small card 4 is placed in the first accommodating space 12 and the front end of the small card 4 resists against the abutting portion 21 of the ejection mechanism 2. A finger pushes the small card 4 and the small card 4 pushes the abutting portion 21 of the push block 20 to move toward the front end of the main body 1. The spring 30 hooked in the second hook portion 22 of the ejection mechanism 2 is stretched subject to the movement of the push block 20, and generating a spring force. At the simultaneous time, subject to the movement of the push block 20, the ejection bar 24 moves along the path of the first guiding groove 28 and reaches a positioning place (from point A along solid arrows through point B to the positioning point C). The small card 4 is then fully inserted into the card connector 100, as shown in Fig. 6.

When the small card 4 is to be ejected from the card connector 100, the finger pushes the small card 4, and the small card 4 pushes the abutting portion 21 of the push block 20 such that the push block 20 moves toward the top of the main body 1. Subject to the movement of the push block 20, the spring 30 hooked in the second hook portion of the ejection mechanism 2 generates a spring-back force. At the simultaneous time, the ejection bar 24 hooked in the push block 20 subject to the movement of the push block 20 moves along the path of the second guiding groove 29 to return to the first guiding groove 28 (from the positioning point C along dotted arrows through point D return to point A), as shown in Fig. 3C. The small card 4 is then in an ejected position from the card connector 100.

Insertion of the big card 5 into the card connector 100, and ejection from the card connector 100, are the same process as with the small card 4.

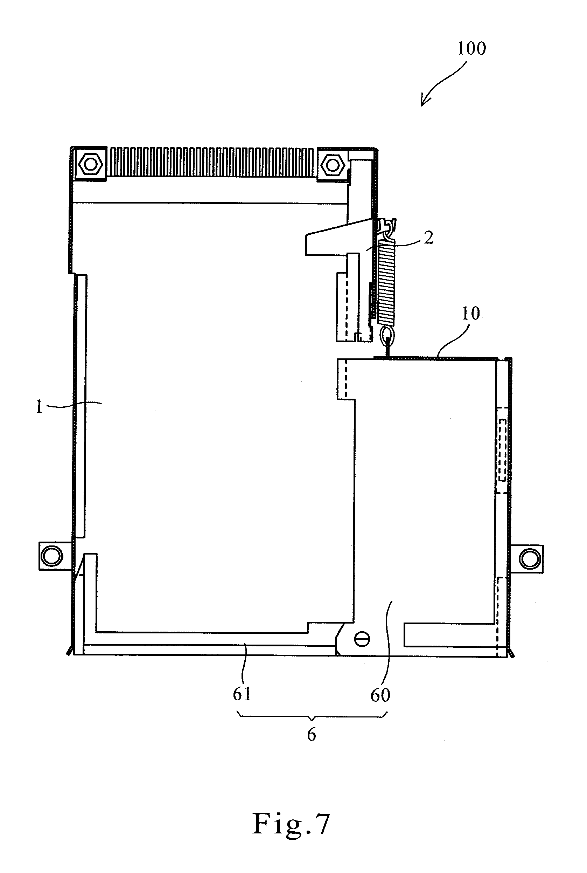

Fig. 7 shows a top view of the card connector 100 according to another embodiment of the present invention. The card connector 100 includes a main body 1, an ejection mechanism 2 and a shield mechanism 6. The main body 1 has a shoulder 10 provided at one lateral side thereof and a plurality of terminals disposed at a front end of the main body 1. The ejection mechanism 2 is disposed at the lateral side of the main body 1 above the shoulder 10 for positioning a card in the card connector 100 or ejecting the card from the card connector 100. The shield mechanism 6 has a fixed plate 60 disposed at the shoulder 10 and an L-shaped block 61 disposed at an insert end of the main body 1. The L-shaped block 61 is pivotably connected with the fixed plate 60.

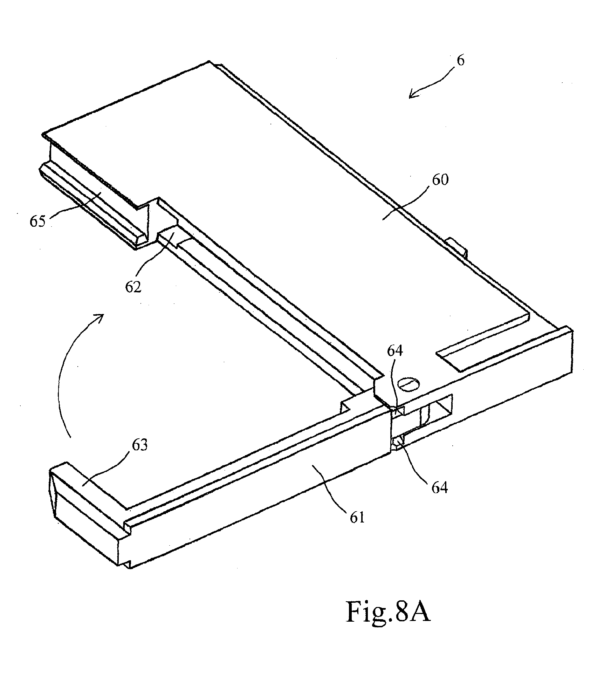

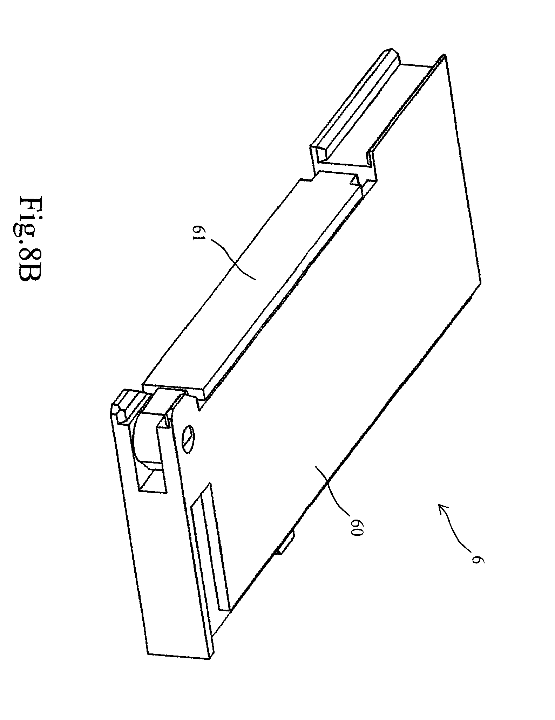

Figures 8A and 8B show the structure of the shield mechanism 6. The fixed plate 60 has a first guiding portion 64 formed at the pivot position of the fixed plate 60 and the L-shaped block 61, a second guiding portion 65 formed at the end opposite to the first guiding portion 64, and a slot 62 formed between the first guiding portion 64 and the second guiding portion 65. The first guiding portion 64 and the second guiding portion 65 are used for guiding the card to rapidly insert the card connector 100. The L-shaped block 61 has a vertical extending portion 63 at one end thereof capable of being received in the slot 62.

In this embodiment, the card connector 100 is used for accommodating the small card 4. When the small card 4 is to be inserted in the card connector 100, the first guiding portion 64 guides the small card 4 to push the L-shaped block 61 forward until the small card reaches the second guiding portion 65. At this time, the vertical extending portion 63 is received in the slot 62, as shown in Fig. 8B. The small card 4 continues to move forward along the second guiding portion 65 until the ejection mechanism 2. Thereafter, the ejection mechanism 2 positions the small card 4 in the card connector 100.

Although the present invention has been described in detail with reference to certain embodiments thereof, those skilled in the art can easily understand that all kinds of alterations and changes can be made within the spirit and scope of the appended claims. Therefore, the spirit and scope of the appended claims should not be limited to the description of the embodiments contained herein.

## Claims

1. A card connector (100) comprising a main body (1) and an ejection mechanism (2), said main body provided with a first hook member (11) at one end thereof, said ejection mechanism (2) including a push block (20), an ejection bar (24), a positioning block (27) and a spring (30), said push block (20) formed with an abutting portion (21) at one side thereof and a second hook member (22) at the opposite side, a through hole (23) formed at said push block (20) above said second hook member (22), said ejection bar (24) formed with an L-shaped bend portion (25) at one end thereof and a protruding guide portion (26) at the opposite end, said positioning block (27) provided with a first guide groove (28) and a second guide groove (29), said spring (30) formed with a fastening portion (31) at each of two opposite ends thereof, wherein said L-shaped bend portion (25) of said ejection bar (24) passes through said through hole (25) of said push block (20) to link said ejection bar (24) and said push block (20), and said protruding guide portion (26) of said ejection bar (24) is received in said first guide groove (28) of said positioning block (27), said first hook member (11) and said second hook member (22) are respectively hooked at the fastening portions (31) of said spring (30) such that said ejection mechanism (2) is positioned at one lateral side of said main body (1), and when a card (4, 5) is inserted into said card connector (100), said card (4, 5) pushes said ejection mechanism (2) and then said spring (30) generates a spring force to rapidly position said card (4, 5) in said card connector (100), and when said card (4, 5) is to be ejected from said card connector (100), said card (4, 5) is forwardly pushed such that said card (4, 5) pushes said ejection mechanism (2), and then said spring (30) generates a spring-back force to eject said card (4, 5) from said card connector (100).

2. The card connector (100) as defined in claim 1, wherein said main body (1) is a composite socket, and a shoulder (10) is disposed at said one lateral side of said main body (1) and under said ejection mechanism (2).

3. The card connector (100) as defined in claim 1 or 2, further comprising a triangular-shaped stopper member (3) disposed at said shoulder (10) for guiding a small card (4) to position in said card connector (100).

4. The card connector (100) as defined in any claim 1, 2 or 3, wherein said composite socket accommodates a card (4, 5) with a specification of Express card/34 or Express card/54.

5. The card connector (100) as defined in any preceding claim, wherein a protruding block (32) extends from an inner wall of said push block (20) for abutting said ejection bar (24).

6. The card connector (100) as defined in any preceding claim, wherein said protruding guide portion (26), which is received in said first guide groove (28), moves along the path of said first guiding groove (28) to a positioning place when said card (4, 5) is inserted into said card connector (100).

7. The card connector (100) as defined in any preceding claim, wherein when said card (4, 5) is to be ejected from said card connector (100), said protruding guide portion (26) moves along the path of said second guide groove (29) back to said first guide groove (28).

8. The card connector (100) as defined in claim 1 or 2, further comprising a shield mechanism (6) having a fixed plate (60) disposed at said shoulder (10) and an L-shaped block (61) disposed at an insert end of said main body (1), said L-shaped block (61) pivotably connected with said fixed plate (60).

9. The card connector (100) as defined in claim 8, wherein said fixed plate (60) has a first guiding portion (64), a slot (62) and a second guiding portion (65), said first guiding portion (64) is disposed at a pivot position between said fixed plate (60) and said L-shaped block (61), said second guiding portion (65) is disposed at one end of said fixed plate (60) opposite to said first guiding portion (64), and said slot (62) is formed between said first guiding portion and said second guiding portion (64), said first guiding portion (64) and said second guiding portion (65) are used for guiding said card (4, 5) during rapid insertion into said card connector (100), and said L-shaped block (61) has a vertical extending portion (63) at one end thereof capable of being received in said slot (62).

10. An ejection mechanism (2) for cooperation with a card connector, comprising:
a push block (20) having an abutting portion (21), a through hole (23) and a hook portion (22), said abutting portion (21) contacting with at least one card inserted in said card connector (100), and said hook portion (22) protruding from said card connector (100);
a positioning block (27) having a plurality of guiding grooves (28,29);
an ejection bar (24) having one end passing through said through hole (23) and the opposite end movable in said guiding grooves (28,29); and
a spring member (30) disposed at one side of said card connector (100) for connecting said hook portion (22) and said card connector (100).

11. The ejection mechanism (2) as defined in claim 11, wherein a protruding block (32) extends from an inner wall of said push block (20) for abutting said ejection bar.

12. The ejection mechanism (2) as defined in any claim 8 to 11, wherein said card connector (100) accommodates a card (4, 5) with a specification of Express card/34 or Express card/54.
